# EUROPEAN PATENT SPECIFICATION

(11) **EP 3 855 486 B1**
(45) Date of publication and mention of the grant of the patent: **30.08.2023**
(21) Application number: 18940342.1
(22) Date of filing: 13.11.2018
(51) Int. Cl.: H01L 23/36, H01L 23/482, H01L 23/367, H01L 23/12

(54) **HIGH-FREQUENCY AMPLIFIER AND HIGH-FREQUENCY AMPLIFIER MODULE**
HOCHFREQUENZVERSTÄRKER UND HOCHFREQUENZVERSTÄRKERMODUL
AMPLIFICATEUR HAUTE FRÉQUENCE ET MODULE D'AMPLIFICATEUR HAUTE FRÉQUENCE

(43) Date of publication of application: 28.07.2021
(73) Proprietor: Mitsubishi Electric Corporation, Tokyo 100-8310 (JP)
(72) Inventor: KAMIOKA, Jun, Tokyo 100-8310 (JP); KUWATA, Eigo, Tokyo 100-8310 (JP); YAMAGUCHI, Yutaro, Tokyo 100-8310 (JP); SHINJO, Shintaro, Tokyo 100-8310 (JP)
(74) Representative: Mewburn Ellis LLP
(86) International application number: PCT/JP2018/041998
(87) International publication number: WO 2020/100219

(56) References cited:
- JP-A- H05 190 563
- JP-A- 2005 183 770
- JP-A- 2012 028 423
- JP-A- 2013 120 854
- JP-A- 2014 116 473
- JP-A- 2015 170 821
- JP-A- 2018 056 318
- JP-A- 2018 056 318
- US-A- 4 794 093
- US-A1- 2002 180 005
- US-A1- 2004 108 556
- US-A1- 2016 086 881

## Description

### TECHNICAL FIELD

The present invention relates to a high frequency amplifier and a high frequency amplifier module.

### BACKGROUND ART

High frequency amplifier modules include a high frequency amplifier that amplifies a high frequency signal, and a functional circuit formed on a module mother board. The high frequency amplifier includes, for example, a field effect transistor (described as an FET hereinafter).

Further, mounting structures for high frequency amplifiers include flip chip mounting in which, for example, an FET chip is placed face down and is connected to a functional circuit via a metal pillar. For example, in JP-A-Sho-58-068954, a package in which an FET is flip chip mounted is described. In this package, a drain pad, a gate pad, and a source pad of the FET are connected to a functional circuit via a metal base which is a metal pillar.

JP 2018-056318 A refers to a semiconductor device, a power supply unit, an amplifier, a heating unit, an exhaust air purification unit, a vehicle, and an information system. US 2004/108556 A1 discloses a semi-conductor device.

### SUMMARY OF INVENTION

### TECHNICAL PROBLEM

In the FET chip which a high frequency amplifier includes, heat is generated mainly in a channel between a source electrode and a drain electrode. In the case in which the heat dissipation characteristic of the high frequency amplifier are low, characteristic degradation, such as a breakdown in the high frequency amplifier or reduction in the gain or the output power of the high frequency amplifier, occurs resulting from the generation of heat from the FET chip. In the FET package described in JP-A-Sho-58-068954, air is placed between the electrodes of the FET. Further, in conventional high frequency amplifiers, a dielectric called an underfill may be disposed between the electrodes of an FET. The underfill is disposed in order to improve the physical strength of connection between the electrodes of the FET and a functional circuit, and typically has a thickness of several tens of micrometers or more. Because the thermal conductivity of air and an underfill each of which is disposed between the electrodes of an FET is remarkably low compared with that of metal, a problem with conventional high frequency amplifiers is that the dissipation characteristic of the heat generated in the transistor toward the mother board are low.

The present invention is made to solve the above-mentioned problem, and it is therefore an object of the present invention to provide a high frequency amplifier and a high frequency amplifier module capable of improving the dissipation characteristic of the heat generated in a transistor toward a mother board as compared with the configuration in which either air or an underfill is placed between the electrodes of a transistor.

### SOLUTION TO PROBLEM

The problem is solved by the subject matter of independent claim 1.

### ADVANTAGEOUS EFFECTS OF INVENTION

According to the present invention, because the pillar member having electrical conductivity and a heat dissipation characteristic is disposed in such a way as to cover the comb - shaped electrodes of the transistor via the thin film dielectric, the dissipation characteristic of the heat generated in the transistor toward a mother board can be improved.

### BRIEF DESCRIPTION OF DRAWINGS

Fig. 1 is a conceptual diagram showing a connecting portion of an FET chip which a high frequency amplifier module according to Embodiment 1 includes;
Fig. 2 is a plane view showing the configuration of the high frequency amplifier according to Embodiment 1;
Fig. 3 is a cross-sectional view on arrow showing a cross section of the high frequency amplifier module according to Embodiment 1, the cross section being taken along the line A-A of Fig. 2;
Fig. 4 is a cross-sectional view on arrow showing a high frequency amplifier module according to Embodiment 2;
Fig. 5 is a cross-sectional view on arrow showing a variant of the high frequency amplifier module according to Embodiment 2; and
Fig. 6 is a cross-sectional view on arrow showing a high frequency amplifier module according to Embodiment 3.

### DESCRIPTION OF EMBODIMENTS

### Embodiment 1.

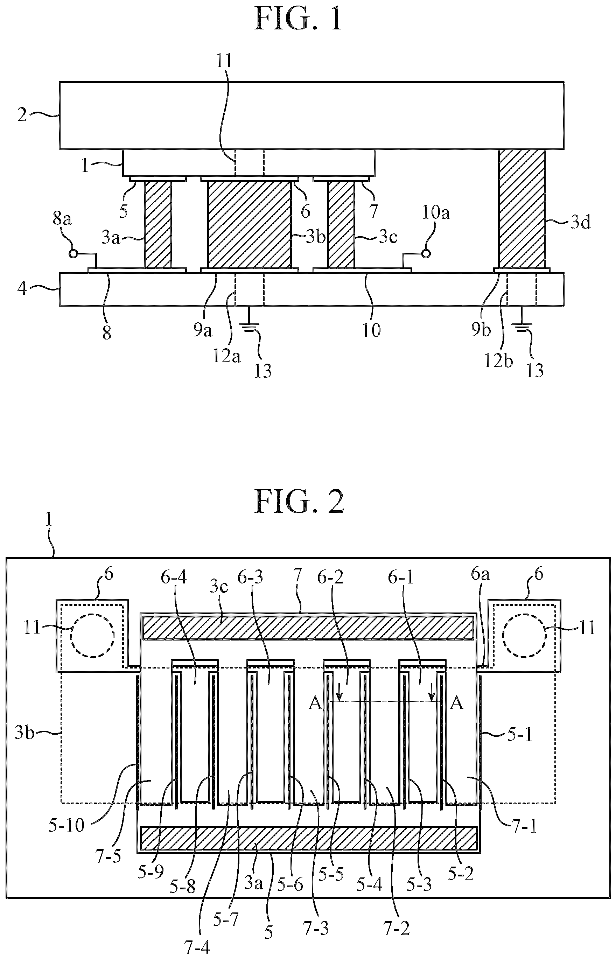

Fig. 1 is a conceptual diagram showing a connecting portion of an FET chip 1 which a high frequency amplifier module according to Embodiment 1 includes, and shows the connecting portion between the FET chip 1 and a mother board 4. The high frequency amplifier module according to Embodiment 1 includes the FET chip 1, a heat sink 2, metal pillars 3a, 3b, and 3c, 3d, and the mother board 4. Further, a high frequency amplifier according to Embodiment 1 includes the FET chip 1 and the metal pillars 3a, 3b, and 3c.

The FET chip 1 is a transistor that amplifies an inputted high frequency signal and outputs the high frequency signal, and is, for example, a GaN transistor formed on a SiC substrate. The heat sink 2 is disposed on a rear surface of the FET chip 1. The heat sink 2 is a member that propagates and dissipates the heat generated in the FET chip 1.

A gate pad 5, source pads 6, and a drain pad 7 are formed on a front surface of the FET chip 1. The gate pad 5 is connected to the metal pillar 3a, and is connected to an input side circuit 8 disposed on the mother board 4 via the metal pillar 3a. The source pads 6 are connected to the metal pillar 3b, and are connected to a ground pad 9a disposed on the mother board 4 via the metal pillar 3b. The drain pad 7 is connected to the metal pillar 3c, and is connected to an output side circuit 10 disposed on the mother board 4 via the metal pillar 3c.

Further, the heat sink 2 is connected to the source pads 6 via via holes 11 formed in the FET chip 1. The heat sink 2 is connected to a ground pad 9b disposed on the mother board 4 via the metal pillar 3d.

The ground pad 9a is connected to a ground 13 of the high frequency amplifier module via a via hole 12a formed in the mother board 4, and the ground pad 9b is connected to the ground 13 via a via hole 12b formed in the mother board 4. As a result, the heat sink 2 is held at a ground potential. In order to strengthen the ground of the heat sink 2, multiple metal pillars 3d and multiple ground pads 9a may be arranged to connect the heat sink 2 to the ground 13.

The input side circuit 8 is connected to an input side terminal 8a of the high frequency amplifier module, and the output side circuit 10 is connected to an output side terminal 10a of the high frequency amplifier module. A high frequency signal is inputted to the input side terminal 8a, and the high frequency signal amplified by the high frequency amplifier is outputted from the output side terminal 10a. In the input side circuit 8 and the output side circuit 10, various types of functional circuits required for the operation of the high frequency amplifier are included. As for the functional circuits, for example, a matching circuit and a bias circuit are provided.

Fig. 2 is a plane view showing the configuration of the high frequency amplifier according to Embodiment 1. In Fig. 2, the metal pillar 3b is illustrated in transparent in such a way that the electrode configuration of the FET chip 1 can be visually recognized. On the front surface of the FET chip 1, the gate pad 5, the source pads 6, the drain pad 7, and multiple finger electrodes including gate fingers 5-1 to 5-10, source fingers 6-1 to 6-4, and drain fingers 7-1 to 7-5 are formed, as shown in Fig. 2.

Each of the gate fingers 5-1 to 5-10 is a narrow stripe-shaped gate electrode, and the gate fingers 5-1 to 5-10 are arranged in parallel and one end of each of the gate fingers is connected to the single gate pad 5, so that a comb-shaped electrode is formed. Each of the source fingers 6-1 to 6-4 is a stripe-shaped source electrode, and the source fingers 6-1 to 6-4 are arranged in parallel and one end of each of the source fingers is connected to a leading line 6a, so that a comb-shaped electrode is formed. The source pads 6 are connected to both respective ends of the leading line 6a. Each of the drain fingers 7-1 to 7-5 is a stripe-shaped drain electrode, and the drain fingers 7-1 to 7-5 are arranged in parallel and one end of each of the drain fingers is connected to the single drain pad 7, so that a comb-shaped electrode is formed.

The source finger 6-1 and the drain finger 7-1 are arranged while sandwiching the gate finger 5-2 therebetween, the source finger 6-1 and the drain finger 7-2 are arranged while sandwiching the gate finger 5-3 therebetween, the source finger 6-2 and the drain finger 7-2 are arranged while sandwiching the gate finger 5-4 therebetween, the source finger 6-2 and the drain finger 7-3 are arranged while sandwiching the gate finger 5-5 therebetween, the source finger 6-3 and the drain finger 7-3 are arranged while sandwiching the gate finger 5-6 therebetween, the source finger 6-3 and the drain finger 7-4 are arranged while sandwiching the gate finger 5-7 therebetween, the source finger 6-4 and the drain finger 7-4 are arranged while sandwiching the gate finger 5-8 therebetween, and the source finger 6-4 and the drain finger 7-5 are arranged while sandwiching the gate finger 5-9 therebetween.

As shown by a broken line in Fig. 2, the metal pillar 3b is a pillar member which is disposed on the front surface of the FET chip 1 in such a way as to cover the gate fingers 5-1 to 5-10, the source pads 6, the source fingers 6-1 to 6-4, and the drain fingers 7-1 to 7-5. The metal pillar 3b has electrical conductivity and a heat dissipation characteristic. The heat generated in the FET chip 1 is propagated toward the mother board 4 through the metal pillar 3b and is dissipated.

A high frequency signal inputted to the input side terminal 8a is inputted to the gate fingers 5-1 to 5-10 via the input side circuit 8, the metal pillar 3a, and the gate pad 5. The high frequency signal inputted to the gate fingers 5-1 to 5-10 is amplified by the FET chip 1, and is outputted from the drain fingers 7-1 to 7-5, via the drain pad 7, the metal pillar 3c, and the output side circuit 10, to the output side terminal 10a. Although the illustration of the bias circuit and so on is omitted in Fig. 1, a proper DC voltage is applied to the gate pad 5 and the drain pad 7 in such a way that the FET chip 1 has a function of amplifying a high frequency signal.

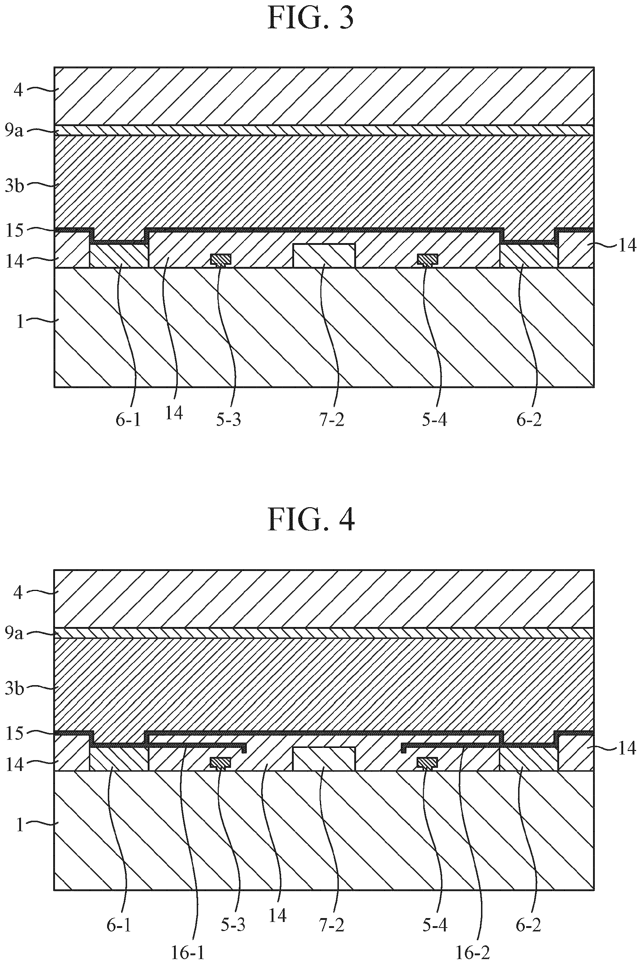

Fig. 3 is a cross-sectional view on arrow showing a cross section of the high frequency amplifier module according to Embodiment 1, the cross section being taken along the line A-A of Fig. 2. In Fig. 3, the illustration of the heat sink 2 is omitted. A thin film dielectric 14 is formed between the gate fingers 5-3 and 5-4, the source fingers 6-1 and 6-2, and the drain finger 7-2. The thin film dielectric 14 is an insulating dielectric layer and is formed using a semiconductor process. The thin film dielectric 14 may have a thickness which can be formed using a normal semiconductor process, and, for example, is formed so as to have a thickness of several micrometers. A rewiring layer 15 is formed between the metal pillar 3b and the thin film dielectric 14. The rewiring layer 15 is a wiring pattern layer and is electrically connected to the metal pillar 3b.

The thin film dielectric 14 is formed on the gate fingers 5-3 and 5-4 and the drain finger 7-2, as shown in Fig. 3. Therefore, the gate fingers 5-3 and 5-4 and the drain finger 7-2 are electrically insulated from the rewiring layer 15 and the metal pillar 3b via the thin film dielectric 14. On the other hand, because no thin film dielectric 14 is formed on the source fingers 6-1 and 6-2, the source fingers 6-1 and 6-2 are electrically connected to the metal pillar 3b via the rewiring layer 15.

The main heating source of the FET chip 1 is a channel region directly under the gate fingers 5-3 and 5-4. On the other hand, the metal pillar 3b is formed in such a way as to substantially cover the whole top of the gate fingers 5-1 to 5-10, the source fingers 6-1 to 6-4, and the drain fingers 7-1 to 7-5. Therefore, because the metal pillar 3b can be a radiation path which is present in the vicinity of the above-mentioned channel region and has a large cross-sectional area shown by the broken line in Fig. 2 and reduced thermal resistance, the dissipation characteristic of the heat generated in the FET chip 1 toward the mother board 4 can be improved.

A main source inductance from the source pads 6 to the ground 13 is a source inductance caused by the metal pillar 3b and the via holes 11. In the high frequency amplifier according to Embodiment 1, because the metal pillar 3b covers the whole tops of the gate fingers 5-1 to 5-10, the source fingers 6-1 to 6-4, and the drain fingers 7-1 to 7-5, its cross-sectional area is large and the source inductance is reduced as compared with the configuration in which a metal pillar is disposed only directly above source fingers. As a result, the gain of the high frequency amplifier is improved.

Next, a process of producing the high frequency amplifier according to Embodiment 1 will be explained.

On the substrate which serves as the FET chip 1, an FET structure including the gate fingers 5-1 to 5-10, the source fingers 6-1 to 6-4, and the drain fingers 7-1 to 7-5 is formed.

After the thin film dielectric 14 is deposited all over the substrate surface on which the above-mentioned FET structure is formed, upper portions of the source fingers 6-1 to 6-4 are exposed by etching only parts of the thin film dielectric 14 on the source fingers 6-1 to 6-4. After that, the rewiring layer 15 is formed on the whole top of the thin film dielectric 14 in which only the upper portions of the source fingers 6-1 to 6-4 are exposed, and the metal pillar 3b is formed on the whole top of the rewiring layer 15. Through these processes, the high frequency amplifier having a section structure shown in Fig. 3 is formed.

Although in the above explanation the high frequency amplifier module in which the FET chip 1 is implemented by a flip chip is shown, the high frequency amplifier may be a monolithic microwave integrated circuit (MMIC) including an FET and a matching circuit. Further, the MMIC may be an amplifier in which multiple FETs are connected in a multistage form via matching circuits.

Further, although in the above explanation the metal pillar 3b is shown, the pillar member that covers the gate fingers 5-1 to 5-10, the source fingers 6-1 to 6-4, and the drain fingers 7-1 to 7-5 may be made of material other than metallic material. More specifically, the pillar member may be made of material other than metal as long as the pillar member has electrical conductivity and a heat dissipation characteristic.

Although in the above explanation the high frequency amplifier including an FET is shown, the transistor used for amplifying a high frequency signal in the high frequency amplifier according to Embodiment 1 is not limited to the FET. More specifically, the transistor may be a bipolar junction transistor as long as the transistor can amplify a high frequency signal.

In the above explanation, the case in which the metal pillar 3b has a cross-sectional shape, as shown in Fig. 2, matching the outside shape of the region in the FET chip 1 in which the gate fingers 5-1 to 5-10, the source fingers 6-1 to 6-4, and the drain fingers 7-1 to 7-5 are formed is shown.

However, the metal pillar 3b in Embodiment 1 may have a cross-sectional shape which can substantially cover the whole top of the above-mentioned region in which the gate fingers 5-1 to 5-10, the source fingers 6-1 to 6-4, and the drain fingers 7-1 to 7-5 are formed. For example, the metal pillar 3b may be a cylindrical member of which a cross-sectional circle substantially covers the whole top of the region in the FET chip 1, the comb-shaped electrodes being formed in the region, and the circle being centered at the central portion of the region. In this case, it is desirable to cover the whole top of the region in which the comb-shaped electrodes are formed, with the thin film dielectric 14, and to further cover the thin film dielectric with the rewiring layer 15.

As mentioned above, in the high frequency amplifier according to Embodiment 1, because the metal pillar 3b having electrical conductivity and a heat dissipation characteristic is disposed in such a way as to cover the tops of the multiple finger electrodes of the FET chip 1 via the thin film dielectric 14, the dissipation characteristic of the heat generated in the FET chip 1 toward the mother board 4 can be improved.

In the high frequency amplifier according to Embodiment 1, the metal pillar 3b covers the upper portions of the gate fingers 5-1 to 5-10, the source fingers 6-1 to 6-4, and the drain finger 7-1 to 7-5, is electrically connected to the source fingers 6-1 to 6-4, and is electrically insulated, via the thin film dielectric 14, from the gate fingers 5-1 to 5-10 and the drain fingers 7-1 to 7-5. As a result, because the source inductance is reduced, the gain of the high frequency amplifier is improved as compared with the configuration in which a metal pillar is disposed only directly above source fingers.

### Embodiment 2.

Fig. 4 is a cross-sectional view on arrow showing a high frequency amplifier module according to Embodiment 2, and shows a cross section of the high frequency amplifier module according to Embodiment 2, the cross section being taken along the line A-A of Fig. 2. In Fig. 4, the same components as those shown in Figs. 1 to 3 are denoted by the same reference signs, and an explanation of the components will be omitted hereinafter. Further, the illustration of a heat sink 2 is omitted.

A high frequency amplifier according to Embodiment 2 includes source field plates 16-1 and 16-2 each extending from above a source finger to above a gate finger adjacent to the source finger, in addition to the components shown in Figs. 1 to 3. The source field plate shown in Fig. 4 is formed in such a way as to extend from a part of a rewiring layer 15 above each of the source fingers 6-1 to 6-4 to above a corresponding one of the gate fingers.

The source field plate 16-1 reduces the electric field between the gate finger 5-3 and a drain finger 7-2, and the source field plate 16-2 reduces the electric field between the gate finger 5-4 and the drain finger 7-2. As a result, the characteristics of the high frequency amplifier according to Embodiment 2 are improved as compared with a high frequency amplifier which does not have any source field plates.

Further, the coupling capacitance between the gate finger 5-3 and a metal pillar 3b is reduced by the source field plate 16-1, and the coupling capacitance between the gate finger 5-4 and the metal pillar 3b is reduced by the source field plate 16-2, and thus the yield rate in the characteristics of the high frequency amplifier according to Embodiment 2 is improved.

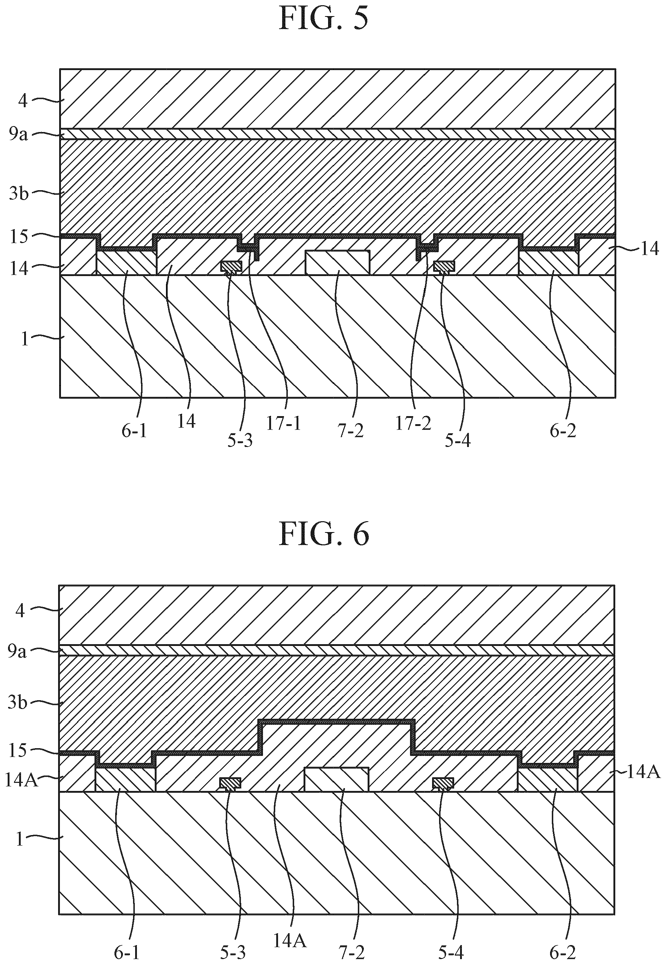

Fig. 5 is a cross-sectional view on arrow showing a variant of the high frequency amplifier module according to Embodiment 2, and shows a cross section of the variant of the high frequency amplifier module according to Embodiment 2, the cross section being taken along the line A-A of Fig. 2. In Fig. 5, the same components as those shown in Figs. 1 to 3 are denoted by the same reference signs, and an explanation of the components will be omitted hereinafter. Further, the illustration of a heat sink 2 is omitted.

The high frequency amplifier shown in Fig. 5 includes source field plates 17-1 and 17-2, in addition to the components shown in Figs. 1 to 3. The source field plates 17-1 and 17-2 shown in Fig. 5 are formed on a rewiring layer 15, and are arranged at least between a gate finger 5-3 and a drain finger 7-2 and between a gate finger 5-4 and the drain finger 7-2, respectively. Source field plates as shown in Fig. 5 are also each formed between a corresponding gate finger and a corresponding drain finger in the FET chip 1, other than between the gate finger 5-3 and the drain finger 7-2 and between the gate finger 5-4 and the drain finger 7-2.

Further, the source field plates 17-1 and 17-2 are electrically connected to source fingers 6-1 to 6-4 via the rewiring layer 15. The provision of the source field plates reduces the parasitic capacitance between the gate fingers and the drain finger, and thus improves the gain of the high frequency amplifier shown in Fig. 5. Further, the reduction in the parasitic inductance of the source field plates 17-1 and 17-2 widens the band of the high frequency amplifier shown in Fig. 5.

As mentioned above, the high frequency amplifier according to Embodiment 2 includes the source field plates 16-1 and 16-2 respectively extending from the source fingers 6-1 and 6-2 to above the gate fingers 5-3 and 5-4. Because of the provision of this configuration, the characteristics of the high frequency amplifier shown in Fig. 4 are improved as compared with a high frequency amplifier which does not have the source field plates 16-1 and 16-2.

In the high frequency amplifier according to Embodiment 2, the rewiring layer 15 disposed between a thin film dielectric 14 and the metal pillar 3b, and electrically connecting the source fingers and the metal pillar 3b, and the source field plates 17-1 and 17-2 formed on the rewiring layer 15 and arranged between the gate fingers and the drain finger are included. Because of the provision of this configuration, the gain and the characteristics of the high frequency amplifier shown in Fig. 5 are improved as compared with a high frequency amplifier which does not have the source field plates 17-1 and 17-2.

### Embodiment 3.

Fig. 6 is a cross-sectional view on arrow showing a high frequency amplifier module according to Embodiment 3, and shows a cross section of the high frequency amplifier module according to Embodiment 3, the cross section being taken along the line A-A of Fig. 2. In Fig. 6, the same components as those shown in Figs. 1 to 3 are denoted by the same reference signs, and an explanation of the components will be omitted hereinafter. Further, the illustration of a heat sink 2 is omitted.

A high frequency amplifier according to Embodiment 3 includes, instead of the thin film dielectric 14 shown in Figs. 1 to 3, a thin film dielectric 14A whose portion covering each of drain fingers 7-1 to 7-5 is made thick. In the high frequency amplifier shown in Fig. 4 or 5, the thin film dielectric 14A may be disposed instead of the thin film dielectric 14.

Because of the provision of the thin film dielectric 14A, the distance between each of the drain fingers 7-1 to 7-5 and a rewiring layer 15 is lengthened, and thus the parasitic capacitance between each of the drain fingers 7-1 to 7-5 and the rewiring layer 15 is reduced. As a result, in the high frequency amplifier according to Embodiment 3, the drain-source capacitance is reduced, and thus the frequency band in which the high frequency amplifier operates is widened.

It is to be understood that the present invention is not limited to the above-mentioned embodiments, and any combination of two or more of the above-mentioned embodiments can be made, various changes can be made in any component according to any one of the above-mentioned embodiments, or any component according to any one of the above-mentioned embodiments can be omitted within the scope of the present invention.

### INDUSTRIAL APPLICABILITY

Because the high frequency amplifier according to the present invention can improve the dissipation characteristic of the heat generated in the transistor toward the mother board, the high frequency amplifier can be used for, for example, wireless communication devices or radar devices.

### REFERENCE SIGNS LIST

1 FET chip, 2 heat sink, 3a, 3b, 3c, and 3d metal pillar, 4 mother board, 5 gate pad, 5-1, 5-2, 5-3, 5-4, 5-5, 5-6, 5-7, 5-8, 5-9, and 5-10 gate finger, 6 source pad, 6-1, 6-2, 6-3, and 6-4 source finger, 6a leading line, 7 drain pad, 7-1, 7-2, 7-3, 7-4, and 7-5 drain finger, 8 input side circuit, 8a input side terminal, 9a and 9b ground pad, 10 output side circuit, 10a output side terminal, 11, 12a, and 12b via hole, 13 ground, 14 and 14A thin film dielectric, 15 rewiring layer, and 16-1, 16-2, 17-1, and 17-2 source field plate.

## Claims

1. A high frequency amplifier comprising:
a transistor (1) having comb-shaped electrodes in which multiple finger electrodes are arranged in parallel;
a pillar member (3b) having electrical conductivity and a heat dissipation characteristic, and covering the comb-shaped electrodes and covering between the comb-shaped electrodes via a thin film dielectric (14, 14A),
wherein the comb-shaped electrodes include multiple gate fingers (5-1 to 5-10), multiple source fingers (6-1 to 6-4), and multiple drain fingers (7-1 to 7-5), and
wherein the pillar member is electrically connected to the source fingers, and is electrically insulated from the gate fingers (5-1 to 5-10) and the drain fingers (7-1 to 7-5) via the thin film dielectric,
**characterized in that**,
the high frequency amplifier further comprises a rewiring layer (15) disposed between the thin film dielectric and the pillar member, and electrically connecting the source fingers and the pillar member.

2. A high frequency amplifier module comprising:
the high frequency amplifier according to any one of claim 1;
a heat sink (2) disposed on the rear of the transistor; and
a mother board (4) having a functional circuit (8, 10) electrically connected to the comb-shaped electrodes.

## Patentansprüche

1. Hochfrequenzverstärker, der Folgendes umfasst:
einen Transistor (1) mit kammförmigen Elektroden, in denen mehrere Fingerelektroden parallel angeordnet sind;
ein Säulenelement (3b), das eine elektrische Leitfähigkeit und eine Wärmeableitungseigenschaft aufweist und die kammförmigen Elektroden bedeckt sowie den Bereich zwischen den kammförmigen Elektroden durch einen dielektrischen Dünnfilm (14, 14A) bedeckt,
wobei die kammförmigen Elektroden mehrere Gate-Finger (5-1 bis 5-10), mehrere Source-Finger (6-1 bis 6-4) und mehrere Drain-Finger (7-1 bis 7-5) umfassen, und
wobei das Säulenelement mit den Source-Fingern elektrisch verbunden und von den Gate-Fingern (5-1 bis 5-10) und den Drain-Fingern (7-1 bis 7-5) durch den dielektrischen Dünnfilm isoliert ist,
**dadurch gekennzeichnet, dass**
der Hochfrequenzverstärker außerdem eine Umverdrahtungsschicht (15) aufweist, die zwischen dem dielektrischen Dünnfilm und dem Säulenelement angeordnet ist und die Source-Finger und das Säulenelement elektrisch verbindet.

2. Hochfrequenzverstärkermodul, das Folgendes umfasst:
einen Hochfrequenzverstärker nach Anspruch 1;
einen Kühlkörper (2), der an der Rückseite des Transistors angeordnet ist; und
eine Hauptplatine (4) mit einer Funktionsschaltung (8, 10), die mit den kammförmigen Elektroden elektrisch verbunden ist.

## Revendications

1. Amplificateur haute fréquence comprenant :
un transistor (1) présentant des électrodes en forme de peigne dans lesquelles des électrodes à doigts multiples sont agencées en parallèle ;
un élément de pilier (3b) présentant une conductivité électrique et une caractéristique de dissipation thermique, et recouvrant les électrodes en forme de peigne et recouvrant entre les électrodes en forme de peigne par l'intermédiaire d'un diélectrique en film mince (14, 14A)
dans lequel les électrodes en forme de peigne incluent de multiples doigts de grille (5-1 à 5-10), de multiples doigts de source (6-1 à 6-4) et de multiples doigts de drain (7-1 à 7-5), et
dans lequel l'élément de pilier est connecté électriquement aux doigts de source, et est isolé électriquement des doigts de grille (5-1 à 5-10) et des doigts de drain (7-1 à 7-5) par l'intermédiaire du diélectrique en film mince,
**caractérisé en ce que**,
l'amplificateur haute fréquence comprend en outre une couche de recâblage (15) disposée entre le diélectrique en film mince et l'élément de pilier, et connectant électriquement les doigts de source et l'élément de pilier.

2. Module amplificateur haute fréquence comprenant :
l'amplificateur haute fréquence selon l'une quelconque des revendications 1 ;
un dissipateur thermique (2) disposé à l'arrière du transistor ; et
une carte mère (4) présentant un circuit fonctionnel (8, 10) connecté électriquement aux électrodes en forme de peigne.
